(19) Europäisches Patentamt
European Patent Office
Office européen des brevets

(11) **EP 1 582 607 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**06.07.2016 Patentblatt 2016/27**

(51) Int Cl.:
***C23C 14/56*** *(2006.01)*

(45) Hinweis auf die Patenterteilung:
**29.10.2008 Patentblatt 2008/44**

(21) Anmeldenummer: **04007820.6**

(22) Anmeldetag: **31.03.2004**

(54) **Schleusenanordnung für eine Vakuumbehandlungsanlage und Verfahren zum Betreiben von dieser**

Loadlock arrangement for a vacuum treatment apparatus and method of operating it

Système de sas pour dispositif de traitement sous vide et procédé de sa mise en oeuvre

(84) Benannte Vertragsstaaten:
**AT BE BG CH CY CZ DE DK EE ES FI FR GB GR HU IE IT LI LU MC NL PL PT RO SE SI SK TR**

(43) Veröffentlichungstag der Anmeldung:
**05.10.2005 Patentblatt 2005/40**

(73) Patentinhaber: **Applied Materials GmbH & Co. KG 63755 Alzenau (DE)**

(72) Erfinder:
• **Gebele, Thomas 63579 Freigericht (DE)**
• **Henrich, Jürgen 63694 Limeshain (DE)**
• **Weimann, Manfred 63755 Alzenau (DE)**

(74) Vertreter: **Bockhorni & Kollegen Elsenheimerstraße 49 80687 München (DE)**

(56) Entgegenhaltungen:
**DE-A- 10 048 210     DE-C- 19 808 163 US-A- 4 504 194**

EP 1 582 607 B2

**Beschreibung**

Die vorliegende Erfindung betrifft eine Schleusenanordnung nach dem Anspruch 1 bzw. dem Oberbegriff des Anspruchs 12 und ein Verfahren zum Betreiben einer mehrstufigen Schleusenanordnung.

Mittels Hochvakuumbeschichtungsanlagen werden beispielsweise Glasscheiben im Hochvakuum bei Drücken im Bereich von 5 x 10 $^{-4}$ hPa bis 1 x 10 $^{-2}$ hPa, insbesondere im Bereich von 3 x 10 $^{-3}$ hPa für Sputterprozesse beschichtet. Um die Produktivität der Anlagen zu erhöhen und nicht bei jedem Substrat die gesamte Anlage und speziell den Hochvakuumbereich evakuieren zu müssen, werden Schleusen zum Ein- und Ausschleusen der Substrate verwendet.

Um den Materialfluss zu verbessern und Durchsatz zu erhöhen, werden in modernen Inline-Beschichtungsanlagen getrennte Schleusenkammern zum Ein- und Ausschleusen verwendet. Eine einfache sogenannte 3-Kammerbeschichtungsanalge besteht aus einer Eintrittsschleuse, in der das Substrat von Atmosphärendruck auf einen geeigneten Übergangsdruck z.B. p = 5E-2 hPa gepumpt wird, eine anschließende Vakuumbeschichtungsstrecke (Prozesskammer) und einer Austrittsschleuse, in der durch Belüftung das Substrat wieder auf Atmosphärendruck gebracht wird.

Die Aufgabe der Schleusen besteht darin, so schnell wie möglich auf einen ausreichenden und möglichst niedrigen Übergangsdruck zum Prozessbereich zu evakuieren. Während das Belüften in wenigen Sekunden ohne Verwendung von Pumpen erfolgen kann, muss zum Evakuieren ein geeigneter Vakuumpumpstand an die Schleuse angeschlossen werden.

Mitentscheidend für die Produktivität und damit den wirtschaftlichen Nutzen einer Inline-Beschichtungsanlage ist die sogenannte Zyklus- bzw. Taktzeit, d.h. die Zeit, die pro Substratbatch aufgewendet werden muss, bevor der nächste Substratbatch in die Anlage gebracht werden kann oder die durchschnittliche Bearbeitungszeit pro Sübsträtbatch im kontinuierlichen Betrieb. Um z. B. eine Zykluszeit von 2 min zu realisieren, muss das Schleusensystem in der Lage sein in t < = 2 min ein Substrat von einem Punkt A an Atmosphäre zu einem Punkt B im (Hoch-)Vacuumbereich zu bringen und umgekehrt. Dazu ist es notwendig, das Substrat in und aus der Schleuse zu transportieren, die Schleuse zu evakuieren bzw. zu belüften und alle zugehörigen Ventile entsprechend zu öffnen bzw. zu schließen. D.h. in einem solchen Fall ist die zum Evakuieren zur Verfügung stehende Zeit stets kleiner als die Zykluszeit (z.B. 90s von 120s), da auch alle anderen Aufgaben (s.o.) innerhalb der Zykluszeit erledigt werden müssen. Nach der bekannten Beziehung:

$$t = \frac{V}{S} \bullet \ln\left(\frac{P_0}{P_1}\right)$$

mit t = Pumpzeit
V = Volumen
S = Saugvermögen
P$_0$ = Startdruck (Atmosphärendruck)
P$_1$ = Zieldruck (Übergabedruck, Umschleusdruck)

ist klar, dass es zwei offensichtliche Möglichkeiten gibt, die Pumpzeit und damit auch die Zykluszeit zu verringern:

➤ Volumenreduzierung der Schleusenkammer
➤ Erhöhung des an die Schleuse angeschlossenen Saugvermögens

Da beiden Möglichkeiten technische und wirtschaftliche Grenzen gesetzt sind, ist man bei Inline-Beschichtungsanlagen mit hoher Produktivität und entsprechend kurzer Zykluszeit dazu übergegangen den Evakuier-/Belüftungsvorgang auf zwei oder mehr Schleusenkammern aufzuteilen. Für z. B. die Einschleusseite bedeutet dies, dass in einer ersten Einschleuskammer von Atmosphäre bis zu einem Zwischendruck z. B. 10 hPa evakuiert wird und in einer zweiten Schleusenkammer dann vom Zwischendruck (bzw. Ausgleichsdruck) bis zum Übergabedruck z.B. 5E-2 hPa. In solch einer 5-Kammeranlage (2 Eintrittsschleusen, 2 Austrittsschleusen, 1 Prozesskammer) wird das Ein- und Ausschleusen auf jeweils zwei Kammern verteilt, erfolgt also in zwei Schritten und ist auf zwei Zyklen verteilt. Damit war es zum Bsp. bei Architekturglasbeschichtungsanlagen mit Schleusenvolumen von ca. 2 m$^3$ bis 5 m$^3$ möglich, die Zykluszeit von ca. 60 s bis 90 s auf ca. 40 s bis 50 s zu senken. Um zu noch kürzeren Zykluszeiten zu gelangen, z.B. t < 30 s, wurde das Prinzip des zweistufigen Schleusens um eine weitere Stufe ergänzt und Anlagen mit je drei Ein-/ bzw. Ausschleuskammem gebaut. Diese sogenannten 7-Kammeranlagen und auch die schnellen 5-Kammeranlagen haben gegenüber den 3-Kammeranlagen die Eigenschaft, dass die reine Pumpzeit (Evakuierzeit) nur ca. die halbe (z.B. 17 s von 35 s) oder bei noch schnelleren Anlagen z.B. nur noch 25% der Zylduszeit (5 s von 20 s) einnimmt, während bei langsamen und älteren Anlagen die Pumpzeit noch den größten Teil der Zykluszeit einnahm (z.B. 60 s von 90 s). Stand der Technik ist es, jeder Schleusenkammer (Schleusenstufe) einen für den jeweiligen Arbeitsbereich geeigneten Vakuumpumpstand zuzuordnen, d.h. z.B. der ersten Einschleuskammer (1) einen atmosphärentauglichen Pumpstand für den Druckbereich 1000 hPa bis z.B. 10 hPa und der zweiten Einschleuskammer (2) einen mehrstufigen z.B. 3-stufigen Röotspumpstand für den Druckbereich 10 hPa bis 2E-2 hPa.

US 4504194 offenbart eine Vorrichtung zum schnellen evakuieren einer Luftschleuse. Zu diesem Zweck wird ein Expansionstank mit mehrfachem Volumen der Luftschleuse bereitgestellt. Eine mit dem Expansionstank verbundene Vakuumpumpe evakuiert diesen. Die Vorrichtung ist jedoch nur für relativ kleine Schleusenkammern geeignet und für Bearbeitungsprozesse in denen die Prozessdauer gross ist gegenüber der Vakuumpumpzeit. Es werden mehrere Kammern und mehrere Expansionstanks gezeigt die weder gleichzeitig noch untereinander verbunden werden können.

Aufgabe der vorliegenden Erfindung ist somit die Leistungsfähigkeit einer Schleusenanordnung für Vakuumbehandlungsanlagen insbesondere der bestehenden 5-Kammer- bzw. 7-Kammersysteme, also mit zwei bis drei Einschleus- und Ausschleuskammern sowie einer Prozesskammer zu verbessern und insbesondere kürzere Evakuierzeiten und somit kürzere Taktzeiten für die Schleusenanordnung zu realisieren. Durch die höhere Leistungsfähigkeit sollen auch die Kosten für die Pumpanordnungen der Schleusenkammern reduziert werden, bzw. Schleusenkammern eingespart werden, was wiederum einen Kosten- und Platzvorteil bieten soll. Weiterhin besteht ein Aspekt der vorliegenden Erfindung darin, niedrigere Ü-bergabedrücke bei gegebenen Zyklus- und Pumpzeiten zu erreichen.

Diese Aufgabe wird gelöst durch eine Schleusenanordnung mit den Merkmalen des Anspruchs 1, sowie einem Verfahren zum Betrieb einer Schleusenanordnung mit den Merkmalen des Anspruchs 23. Vorteilhafte Ausgestaltungen sind Gegenstand der abhängigen Ansprüche.

Die vorliegende Erfindung beruht nach einem ersten Aspekt auf der Erkenntnis, dass die Leistungsfähigkeit der Pumpanordnungen und somit die Zeit für das Evakuieren von Schleusenkammern verbessert bzw. verkürzt werden kann, wenn die Pumpanordnungen variabel den entsprechenden Bedürfnissen an den einzelnen Einschleuskammern angepasst werden, insofern als ein möglichst hoher zeitlicher Einsatz der Pumpanordnungen angestrebt wird. Damit kann durch Ausnutzung bestehender Pumpressourcen eine Erhöhung der effektiven Pumpleistung bzw. eine frühere Übergabe des Substrats von einer Einschleuskammer zur anderen realisiert werden. Gemäß der Erfindung wird somit nicht mehr starr daran festgehalten, dass eine Pumpeinrichtung für eine bestimmte Einschleuskammer zur Verfügung steht, sondern die Grundidee der Erfindung besteht darin, dass verschiedene Pumpeinrichtungen während des Einschleusvorgangs in geeigneter Weise mit einander gruppiert oder verbunden bzw. umgruppiert werden, um eine optimale Absaugleistung zu erreichen bzw. ein möglichst frühzeitiges Übergeben von einer Schleusenkammer zur anderen bei noch hohen Übergabedrücken zu ermöglichen.

Entsprechend wird eine erste Pumpeinrichtung, die primär für eine erste Schleusenkammer vorgesehen ist, nicht nur für diese verwendet, sondern auch für eine zweite Schleusenkammer, wobei lediglich entsprechende Verbindungen von der Pumpeinrichtung zu der ersten Schleusenkammer und zur zweiten Schleusenkammern vorgesehen werden müssen. Auf diese Weise ist es möglich, je nach Bedarf und Stadium des Einschleusprozesses die Pumpleistung bzw. Saugvermögen der ersten Pumpeinrichtung entweder der ersten Einschleuskammer oder der zweiten Einschleuskammer oder beiden gleichzeitig zur Verfügung zu stellen.

Ferner wird diese erste Pumpeinrichtung, nicht nur direkt und unmittelbar der zweiten Einschleuskammer zur Verfügung gestellt, sondern die erste Pumpeinrichtung wird zusätzlich bzw. alternativ als Vorpumpstufe für eine zweite Pumpeinrichtung dieser nachgeschaltet, die primär für das Abpumpen der zweiten Schleusenkammer vorgesehen ist.

Somit kann die Einsatzmöglichkeit der ersten Pumpeinrichtung weiter erhöht und die Pumpleistung besser verteilt werden.

Nach einer bevorzugten Ausrührungsform wird eine dritte Pumpeinrichtung vorgesehen, die als nachgeschaltete Pumpstufe für die zweite Pumpeinrichtung, insbesondere im Bereich der Schleusenkammer mit niedrigeren Drücken die zweite Pumpeinrichtung unterstützt und zwar insbesondere dann, wenn die erste Pumpeinrichtung als Vorpumpstufe nicht mehr zur Verfügung steht, da sie hauptsächlich für die erste Schleusenkammer Verwendung finden soll.

Gemäß einer weiteren vorteilhaften Ausgestaltung der vorliegenden Erfindung kann bei parallel nebeneinander geschalteten Pumpen einer Pumpeinrichtung ein entsprechender By-pass vorgesehen werden, so dass eine der parallel geschalteten Pumpen durch entsprechendes Freischalten des Bypasses und geeignetes Abtrennen der übrigen Verbindungsleitungen diese Pumpe zu den vorher parallel geschalteten Pumpen in Reihe nachgeschaltet wird, um einen mehrstufigen Pumpstand zu erzeugen. Dies hat den Vorteil, dass je nach erforderlicher Pumpleistung bzw. Druckverhältnissen durch einfache Umgruppierung der Pumpen die Pumpleistung dem Bedarf angepasst werden kann. Beispielsweise für den Fall, dass die erste Pumpeinrichtung als Vorpumpstufe für die zweite Pumpeinrichtung zur Verfügung steht, kann die entsprechende Pumpe parallel mit den anderen Pumpen in der zweiten Pumpeinrichtung betrieben werden, während bei einem Abschalten der ersten Pumpeinrichtung als Vorpumpstufe die Pumpe mit dem Bypass, den anderen Pumpen der zweiten Pumpeneinrichtung nachgeschaltet wird, um mit diesen einen mehrstufigen Pumpstand zu bilden.

Gemäß einer weiteren vorteilhaften Gestaltung kann bei parallel nebeneinander geschalteten Pumpen insbesondere der zweiten Pumpeinrichtung für die zweite Schleusenkammer parallel zu diesen Pumpen eine differenzdruckgesteuerte Umwegklappe vorgesehen werden, so dass automatisch nach den vorherrschenden Druckverhältnissen die parallelen Pumpeinrichtungen, insbesondere die zweite Pumpeinrichtung auch bei hohen Ansaugdrücken betrieben werden können. Durch die Differenzdruckklappe K2 wird nämlich die Ausblasseite der parallel geschalteten Pumpen mit der Ansaugseite, beispielsweise über die zweite Schleusenkammer, verbunden bzw. kurzgeschlossen, um einen maximalen Differenzdruck einzurichten. Dadurch wir die maximale Kompression der parallel geschalteten Pumpen und damit auch ihre mechanische bzw. elektrische Leistungsaufnahme begrenzt, so dass diese Pumpen bereits bei viel höheren Ansaugdrücken verwendet werden können, als ohne Umwegklappe. Dadurch können derartige parallel geschaltete Pumpen, beispielsweise Rootspumpen, auch bei relativ hohen Drücken schon mitpumpen und ihr Saugvermögen in einer frühen Abpumpphase zur Verfügung stellen. Auf diese Weise kann auf aufwändige Pumpen für die zweite Pumpeinrichtung, wie beispielsweise voreinlassgekühlte Wälzkolbenpumpen (Rootspumpen), die einen hohen zulässigen Differenzdruck von beispielsweise > 800 hPa beherrschen können, verzichtet werden. Außerdem ist es damit möglich die zweite Pumpeinrichtung ständig an der zweiten Schleusenkammer angeschlossen zu lassen, ohne dass entsprechende Ventile in den Leitungen zu der Schleusenkammer geschlossen werden müssten. Auch dadurch ergibt sich eine bessere Auslastung der Pumpen der zweiten Pumpeinrichtung bzw. eine vereinfachte Gestaltung der Pumpanordnung. Statt einer einzigen parallel geschalteten Umwegklappe kann jeder Pumpe eine eigene Differenzdruckklappe zugeordnet werden oder es können Pumpen mit integrierten Umwegklappe (Differenzdruckventilen) eingesetzt werden.

Es ist selbstverständlich, dass die verschiedenen Pumpeinrichtungen ein oder mehrere parallel zueinander geschaltete ein- oder mehrstufige Vakuumpumpen umfassen können, wie z. B. ölabgedichtete oder trockenverdichtende Vakuumpumpen, insbesondere Drehschieberpumpen, Kreiskolbenpumpen, Sperrschieberpumpen, Wälzkolbenpumpen, Trockenläufer, insbesondere Schraubenpumpen, Rootspumpen, insbesondere voreinlassgekühlte Rootspumpen usw.

Durch die variable Gestaltung der Pumpleistung ist es insbesondere auch möglich ganz auf ölabgedichtete Pumpeinrichtungen zu verzichten und nur trockenverdichtende Vakuumpumpen wie z. B. Schraubenpumpen zu verwenden.

Nach einem zweiten Aspekt wird eine Beschleunigung des Schleusenvorgangs dadurch erreicht, dass Puffereinrichtungen vorgesehen werden, die ein Puffervolumen zur Verfügung stellen, welches beispielsweise in Zeiten, in denen das Saugvermögen bestimmter Pumpeinrichtungen für den unmittelbaren Evakuierprozess nicht benötigt wird, oder ein direktes Abpumpen noch nicht möglich ist, evakuiert wird. Auf diese Weise wird sozusagen das Saugvermögen bzw. die Pumpleistung in der Puffereinrichtung gespeichert und im richtigen Zeitpunkt durch einen schlagartigen Druckausgleich für die Evakuierung bzw. Druckabsenkung der Schleusenkammern zur Verfügung gestellt. Der schlagartige Druckausgleich ermöglicht eine sehr schnelle Evakuierung innerhalb von Bruchteilen von Sekunden, also nahezu in "Nullzeit".

Vorzugsweise kann für jede Schleusenkammer eine eigene Puffereinrichtung mit einem entsprechenden Puffervolumen zur Verfügung gestellt werden, wobei zusätzlich zu diesen externen Puffereinrichtungen die Schleusenkammern selbst ebenfalls als Puffer dienen können, wenn nämlich die dem Vakuumbereich näherliegende Schleusenkammer vorevakuiert wird, um dann durch einen Druckausgleich mit einer vorgeschalteten Schleusenkammer für eine schlagartige Druckabsenkung zu sorgen.

Die externen Puffereinrichtungen können mit separaten Pumpeinrichtungen versehen sein, wobei es jedoch besonders zweckmäßig ist für die für die Schleusenkammern bereits vorhandenen Pumpeinrichtungen alleine oder zusätzlich zu separaten Pumpeinrichtungen der Puffereinrichtungen mit einzusetzen. Auf diese Weise kann eine optimale Ausnutzung der Pumpeinrichtungen der Schleusenanordnung gewährleistet werden.

Es ist für den Fachmann selbstverständlich, dass die beschriebenen Maßnahmen sowohl an der Einschleus- als auch an der Ausschleusseite verwirklicht werden können.

Weitere Vorteile, Kennzeichen und Merkmale der vorliegenden Erfindung werden bei der nachfolgenden, detaillierten Beschreibung bevorzugter Ausführungsformen anhand der beigefügten Zeichnungen deutlich. Die Zeichnungen zeigen dabei in rein schematischer Weise in

Fig. 1 eine schematische Darstellung des Einschleusbereichs einer Glasbeschichtungsanlage mit entsprechender Pumpanordnung;

Fig. 2 eine weitere Ausführungsform einer Schleusenanordnung in einem Einschleusbereich vergleichbar der Darstellung in Fig. 1,

Fig. 3 eine dritte Ausrührungsform eines Einschleusbereichs mit einer zu Fig. 1 ähnlichen Darstellung; und in

Fig. 4 eine vierte Ausführungsform einer Schleusenanordnung.

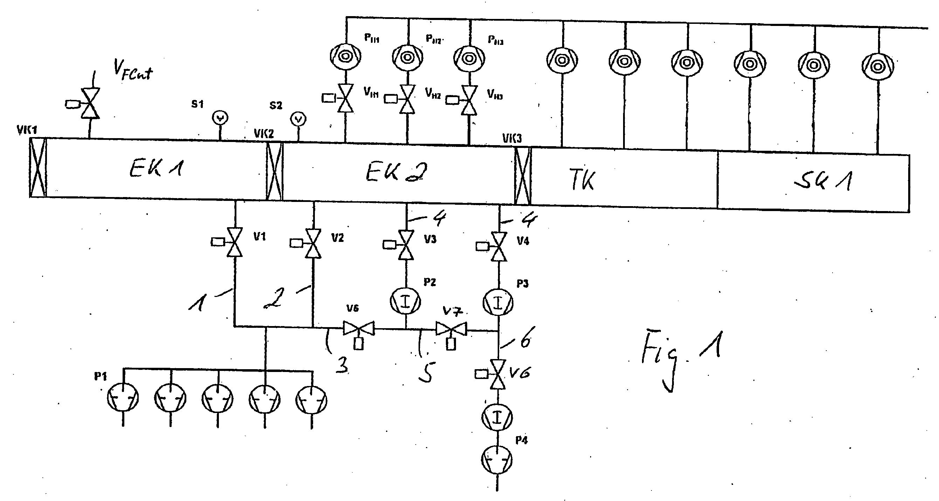

Fig. 1 zeigt in einer schematischen Darstellung den Einschleusbereich einer Vakuumbehandlungsanlage, hier Glasbeschichtungsanlage mit zwei Einschleuskammern EK1 und EK2, sowie eine Transferkammer TK und eine Sputterkammer SKI. An der Sputterkammer SKI und der Transferkammer TK sind eine Vielzahl Hochvakuumpumpen angeordnet, um die Hochvakuumbedingungen für den Beschichtungsbereich einzustellen.

Die Einschleuskammern EK1 und EK2 sind gegenüber der äußeren Umgebung durch die Ventilklappe VK1, sowie gegenüber der Transferkammer TK über die Ventiklappe VK3 abgetrennt. Untereinander wird die Trennung durch die Ventilklappe VK2 bewirkt.

An der Einschleuskammer EK1 ist ein Ventile $V_{Flut}$ zum Belüften der Einschleuskammer EK1 angeordnet.

An der Einschleuskammer EK1 ist ferner eine erste Pumpeinrichtung P1 mit fünf parallel geschalteten Drehschieberpumpen vorgesehen, die über die Leitung 1 und das Ventil V1 mit der Einschleuskammer EK1 verbunden ist. Die Pumpeinrichtung P1 ist darüber hinaus über die Leitung 2 und das Ventil V2 mit der Einschleuskammer EK2 verbunden. Ferner ist die Pumpeinrichtung P1 noch über die Leitung 3, welche durch das Ventil V5 abschließbar ist, mit der zweiten Pumpeinrichtung P2, P3, die durch die parallel geschalteten Rootspumpen P2 und P3 gebildet wird, verbunden.

Die Rootspumpen P2 und P3 der zweiten Pumpeinrichtung sind untereinander über die Leitung 5 an der Ausblasseite miteinander verbunden, wobei die Leitung 5 über das Ventil V7 absperrbar ist. Im übrigen sind die Pumpen P2 und P3 über die Leitungen 4 und den darin vorgesehenen Ventilen V3 und V4 mit der Einschleuskammer EK2 verbunden. Darüber hinaus ist eine dritte Pumpeinrichtung P4 aus einem zweistufigen Rootspumpenstand mit einer Rootspumpe und einer nachgeschalteten Drehschieberpumpe vorgesehen, die über die Leitung 6, welche das Ventil V6 aufweist, mit der zweiten Pumpeinrichtung und hier insbesondere mit der Leitung 5 verbunden ist.

Darüber hinaus sind an der Einschleuskammer EK2 Hochvakuumpumpen vorgesehen, die parallel zueinander geschaltet sind und über die Ventile Vh1 bis Vh3 an die Einschleuskammer 2 zuschaltbar sind.

Das Einschleusen in eine derartige Schleusenanordnung erfolgt in der Weise, dass zunächst die Ventilklappe VK1 der ersten Einschleuskammer EK1 geöffnet wird und das Substrat in die Einschleuskammer EK1 transportiert wird. Danach wird die Ventilklappe VK1 geschlossen und das Ventil V1 zum Pumpstand P1 geöffnet, so dass die Einschleuskammer EK1 abgepumpt werden kann.

Danach werden die Ventile V3, V4 und V5 geschlossen und das Ventil V2, sowie die Ventilklappe VK2 geöffnet. Dies geschieht beispielsweise bei einem Druck von 200 hPa. Gleichzeitig wird das Substrat nun von der ersten Einschleuskammer EK1 in die zweite Einschleuskammer EK2 transportiert.

Wenn ein geeigneter Druck erreicht ist, beispielsweise 80 hPa, werden die Ventile V5 und V3 geöffnet und die Ventile V1 und V2 geschlossen. Gleichzeitig oder mit geringer Verzögerung werden die Ventile V4 und V7 geöffnet. Nunmehr wird auch das Ventil V6 geöffnet, wobei jedoch dieses Ventil V6 optional vorhanden ist und nur bei einer bestimmten Art des Pumpstandes P4 vorhanden sein muss. Wird beispielsweise die dritten Pumpeinrichtung P4 aus einer Vorpumpe. und einer Rootspumpe mit Umwegleitung gebildet, kann aus das optionale Ventil V6 verzichtet werden, da dann die dritte Pumpeinrichtung P4 bei Atmosphäre oder sehr hohen Ansaugdrücken, z. B. 100 hPa bis 300 hPa zugeschaltet bzw. durchgängig betrieben werden kann.

Anschließend werden die Ventile V1 und die Ventilklappe VK2 geschlossen, so dass die Einschleuskammer EK1 wieder belüftet und die Ventilklappe VK1 geöffnet werden kann, um das nächste Substrat in der Einschleuskammer EK1 aufzunehmen.

Ferner wird nun das Ventil V5 geschlossen, so dass nicht mehr die erste Pumpeinrichtung P1 als Vorpumpstand für die zweite Pumpeinrichtung P2, P3 bzw. parallel zur dritten Pumpeinrichtung P4 arbeitet, sondern nur noch die dritte Pumpeinrichtung P4 als Haltepumpstand der zweiten Pumpeinrichtung P2, P3 nachgeschaltete ist, während die erste Pumpeinrichtung durch das Öffnen des Ventils VI wieder zum Evakuieren der ersten Einschleuskammer EK1 eingesetzt wird.

In der zweiten Einschleuskammer EK2 können nunmehr die optionalen Hochvakuumventile Vh1 bis Vh3 geöffnet werden, um die Einschleuskammer EK2 auf Hochvakuumbedingungen bis Vh3 geöffnet werden, um die Einschleuskammer EK2 auf Hochvakuumbedingungen zu bringen. Bei einem Druck von ca. 0,3 hPa können die Ventile V3 und V4 geschlossen werden und nach Erreichen der entsprechenden Vakuumbedingungen z. B. bei einem Druck von $2 \times 10^{-3}$ hPa kann die Ventilklappe VK3 geöffnet werden, um das Substrat in den Prozessbereich (Transferkammer) überzuführen.

Wichtig hierbei ist, dass die oben beschriebenen Vorgänge in bzw. an den beiden Einschleuskammern zum Teil gleichzeitig ablaufen, so dass eine möglichst geringe Zykluszeit erreicht wird. Dadurch, dass die ersten Pumpeinrichtung P1 nicht nur mit der Einschleuskammer EK1, sondern auch mit der zweiten Einschleuskammer EK2 verbunden ist, kann die erste Pumpeinrichtung P1 für einen längeren Zeitraum genutzt werden, um damit zu einer verkürzten Einschleuszeit beizutragen.

Vorteilhaft ist bei der beschriebenen Anordnung, bzw. dem beschriebenen Vorgehen, dass die Ventilklappe VK2 zwischen der Einschleuskammer EK1 und Einschleuskammer EK2 nicht erst bei dem Übernahmedruck der Rootspumpen P2 und P3 der zweiten Pumpeinrichtung, also bei ca. 15 hPa geöffnet werden kann, sondern schon bei höheren Drücken, im Bereich von 100 hPa bis 200 hPa insbesondere 150 hPa. Dadurch verringert sich die Pumpzeit in der Einschleuskammer EK1 um beispielsweise ein Drittel oder die Pumpeinrichtung P1 könnte hinsichtlich des Saugvermögens um ein Drittel verkleinert werden.

Darüber hinaus ist vorteilhaft, dass die erste Pumpeinrichtung P1 über das Ventil V5 als Vorpumpstand der zweiten Pumpeinrichtung mit den Pumpen P2 und P3 eingesetzt werden kann, so dass die zweite Pumpeinrichtung mit den Pumpen P2 und P3 bei viel höheren Drücken eingesetzt werden kann. Hier ist schon ein Einsatz ab ca. 100 hPa statt bei 10 hPa möglich.

Insbesondere können die Öffnungs- und Schließzeiten der verschiedenen Ventile, insbesondere das Öffnen von V5, V7, V3 und V4, sowie das Schließen von V2 so aufeinander abgestimmt werden, dass keine Unterbrechung des Saugvermögens entsteht und die Schaltzeiten die Zykluszeit nicht negativ beeinflussen.

Die dritte Pumpeinrichtung P4 hat die Aufgabe mit der zweiten Pumpeinrichtung P2, P3 einen mehrstufigen Pumpstand zu bilden, bis der notwendige Übergabedruck bzw. der Einschaltdruck für die optionalen Hochvakuumpumpen $P_{H1}$ bis $P_{H3}$ erreicht ist. Außerdem dient die dritte Pumpeinrichtung P4 dazu die zweite Pumpeinrichtung P2, P3 zu unterstützen, wenn die ersten Pumpeinrichtung P1 zum Evakuieren der Einschleuskammer EK1 benötigt wird und deshalb als Vorpumpstand für die zweite Pumpeinrichtung P2, P3 nicht mehr zur Verfügung steht.

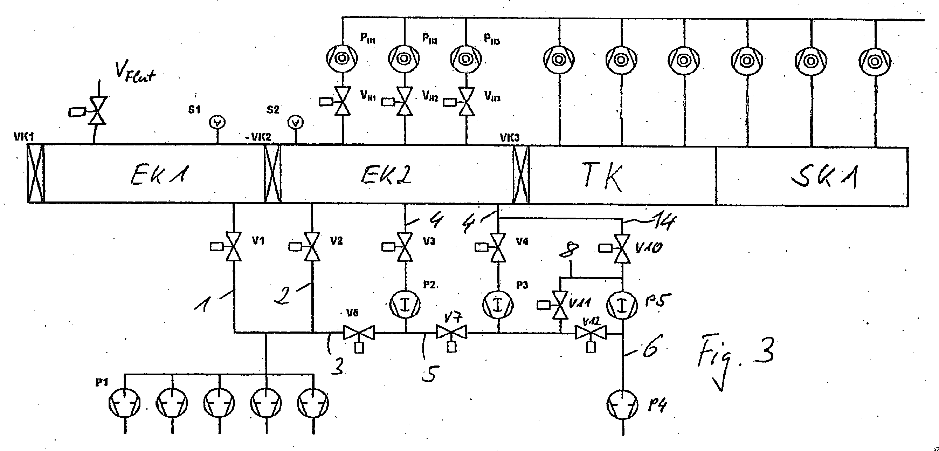

Bei der alternativen Ausführungsform der Fig. 3, die in weiten Teilen derjenigen der Fig. 1 entspricht und von daher im Folgenden nur bezüglich der Unterschiede beschrieben werden soll, ist bei der zweiten Pumpeinrichtung zusätzlich zu den Rootspumpen P2 und P3 eine dritte Rootspumpe P5 parallel geschaltet, die über eine weitere Leitung 14 und dem darin angeordneten Ventil V10 mit der Einschleuskammer EK2 verbunden ist. Darüber hinaus ist parallel zur dritten Pumpe P5 eine Leitung 8 vorgesehen, die zwischen der Einschleuskammerleitung 14 und der die Ausblasseite der Pumpen P2, P3 und P5 verbindenden Leitung 5 angeordnet ist, wobei wiederum ein Ventil V11 in der Leitung 8 vorgesehen ist. Die Leitung 8 mündet zwischen dem Ventil V10 und der Pumpe P5 in die Leitung 14. Außerdem ist ein Ventil V12 zwischen der Einmündung der Leitung 8 in die Leitung 5 und der Einmündung der Leitung 6 in die Leitung 5 vorgesehen. Diese Bypassanordnung zur Pumpe P5 ermöglichstes, die Pumpe P5 durch Schließen des Ventils V10, sowie des Ventils V12 und Öffnen des Ventils V11 den Rootspumpen P2 und P3 nachzuschalten, so dass die Pumpe P5 mit der dritten Pumpeinrichtung P4, die hier durch eine einstufige Pumpanordnung aus einer Drehschieberpumpe gebildet ist, einen mehrstufigen Rootspumpenstand bildet.

Insofern ist es möglich zu dem Zeitpunkt, an dem die erste Pumpeinrichtung P1 nicht mehr als nachgeschaltete Pumpstufe für die zweite Pumpeinrichtung zur Verfügung steht, weil die erste Pumpeinrichtung P1 wieder die Einschleuskammer EK1 abpumpen muss, eine leistungsfähige mehrstufige Pumpanordnung für die Einschleuskammer EK2 durch Umgruppierung der Pumpe P5 bzw. Nachschaltung der Pumpe P5 zu den Pumpen P2 und P3 zu erreichen. Entsprechend werden bevor das Ventil V5 oder V7 geschlossen wird, die Ventile V10 und V12 geschlossen und das Ventil V11 geöffnet, um die Pumpe P5 den Pumpen P2 und P3 in Reihe nachzuschalten. Ansonsten entspricht der Ablauf demjenigen des Einschleusens in den Einschleusbereich der Fig. 1. Der Vorteil dieser Variante liegt jedoch darin, dass während des Abpumpens mit der zweiten Pumpeinrichtung P2, P3, P5 durch Schließen der Ventile V10 und V12 und Öffnen des Ventils V11 einen dreistufiger Rootspumpenstand mit der zweiten sowie dritten Pumpeinrichtung P4 als Vorpumpe bilden kann. Die dritte Stufe mit den Rootspumpen P2 und P3 kann durch Öffen/Schließen von V7 verdoppelt bzw. halbiert werden bzw. zwischen der ersten Pumpeinrichtung P1 und der dritten Pumpeinrichtung P4 aufgeteilt werden.

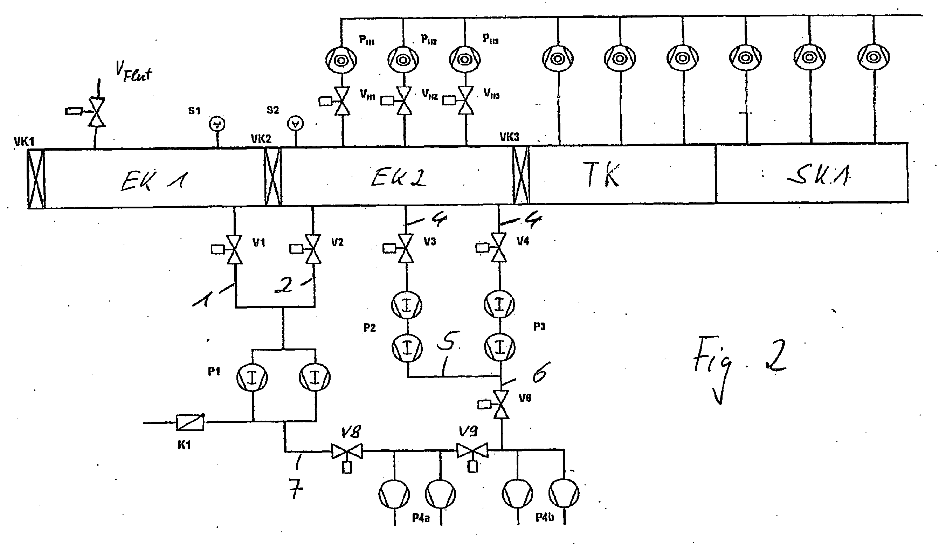

Bei der Ausführungsform der Fig. 2 ist die erste Pumpeinrichtung durch zwei parallel geschaltete, einstufig ausgebildete voreinlassgekühlte Rootspumpe gebildet, die über die Leitung 1 und das Ventil V1 mit der Einschleuskammer EK1 und über die Leitung 2 und das Ventil V2 mit der Einschleuskammer EK2 verbunden sind. (Die Voreinlassgaskühlung ist nicht dargestellt)

Die zweite Pumpeinrichtung besteht aus den zweistufigen parallelen Rootspumpen P2 und P3, die wiederum über die Leitungen 4 und entsprechende Ventile V3 und V4 mit der Einschleusklammer EK2 verbunden sind.

An der Ausblasseite der ersten Pumpeinrichtung P1 und der zweiten Pumpeinrichtung P2, P3 ist eine dritte Pumpeinrichtung P4a, P4b aus parallel geschalteten einstufigen Trockenläufern z. B. in Form von Schraubenpumpen vorgesehen, welche über die Leitung 6 mit der zweiten Pumpeinrichtung P2, P3 bzw. deren gemeinsamen Leitung 5 verbunden sind, bzw. über die Leitung 7 mit der ersten Pumpeinrichtung P1. In der Leitung 6 befindet sich das Ventil V6 und in der Leitung 7 das Ventil V8, so dass die entsprechenden Verbindungen abgetrennt werden können. Zusätzlich befindet sich in der Verbindungsleitung zwischen den parallel geschalteten Schraubenpumpen P4a und P4b ein Ventil V9. Mit der Ausführungsform der Fig. 2 kann sowohl die Einschleuskammer EK1 als auch die Einschleuskammer EK2 über mehrstufige Pumpenstände abgepumpt werden, wobei insbesondere durch diese Anordnung auf ölgedichtete Vorpumpen verzichtet werden kann, sondern alternativ in besonders vorteilhafter Weise ausschließlich trockenverdichtende Pumpen eingesetzt werden können.

Das Einschleusen eines Substrats in die Vakuumbehandlungsanlage der Fig. 2 erfolgt in der Weise, dass zunächst die Ventilklappe VK1 der ersten Einschleuskammer EK1 geöffnet wird und das Substrat in die Einschleusammer EK1 transportiert wird. Danach wird die Ventilklappe VK1 geschlossen und das Ventil V1 zur ersten Pumpeinrichtung P1 geöffnet, das bei hohem Drücken geförderte Gas, z. B. bei 500 bis 1000 hPa wird abhängig vom Vorpumpstand der dritten Pumpeinrichtung P4 über die Ausblasklappe K1 an die Atmosphäre ausgeblasen. Ab einem Übernahmedruck Pü von beispielsweise 300 hPa wird das Ventil V8 bzw. V8 und V9 geöffnet, so dass eine mehrstufige Pumpanordnung zum Abpumpen der Einschleuskammer EK1 gebildet wird.

Nunmehr werden die Ventile V3 und V4 geschlossen, während das Ventil V2 und die Ventilklappe VK2 zwischen der Einschleuskammer EK1 und der Einschleuskammer EK2 geöffnet werden. Das Substrat wird nun von der ersten Einschleuskammer EK1 in die zweite Einschleuskammer EK2 transportiert.

Danach werden die Ventile V6, V3 und V4 geöffnet und ggf. die Ventile V8 und V9 geschlossen. Dann wird die Ventilklappe VK2 und das Ventil V1 wieder geschlossen, so dass die Eintrittskammer bzw. Einschleuskammer EK1 belüftet und die Ventilklappe VK1 geöffnet werden kann, um das nächste Substrat in die Einschleuskammer EK1 einzubringen. Danach werden die Ventile V8 und V2 geschlossen und V1 zum Evakuieren der ersten Einschleuskammer EK1 geöffnet. Die Hochvakuumpumpen $P_{H1}$ bis $P_{H3}$ können entsprechend dem Betrieb des ersten Ausführungsbeispiels gemäß der Fig. 1 über die Ventile Vhl bis Vh3 mit der Einschleuskammer EK2 verbunden werden, so dass dann die Ventile V3 und V4 geschlossen werden können. Wenn die Einschleuskammer EK2 den Vakuumbedingungen der Sputterkammer 1 entspricht, wird die Ventilklappe VK3 geöffnet und das Substrat wird in den Prozessbereich eingeschleust. Auch hier laufen selbstverständlich die Vorgänge in den beiden Schleusenkammern EK1 und EK2 zum Teil zeitgleich ab.

Der Vorteil dieser Anordnung besteht darin, dass die erste Pumpeinrichtung P1 und zudem auch die dritte Pumpeinrichtung P4 nahezu zu 100 % genutzt werden können, also nahezu über den gesamten Einschleuszyklus. Außerdem kann auch hier das Kammerventil VK2 bereits bei höheren Drücken, beispielsweise bei 100 bis 400 hPa, insbesondere 250 hPa geöffnet werden, was gegenüber einer Öffnung bei ca. 15 hPa, welcher dem Übernahmedruck der Rootspumpen P2 und P3 entspricht, eine deutlich verkürzte Pumpzeit für das Abpumpen der Einschleuskammer EK1 entspricht bzw. eine verkleinerte Ausbildung des entsprechenden Pumpstands ermöglicht.

Durch die variable Einsetzbarkeit einer dritten Pumpeinrichtung P4 als Vorpumpstand sowohl der ersten Pumpeinrichtung P1 als auch der zweiten Pumpeinrichtung P2, P3, wird zudem sowohl für die Einschleuskammer EK1 als auch für die Einschleuskammer EK2 ein variabel zu nutzender mehrstufiger Pumpstand bereitgestellt. Insbesondere kann bei allen gezeigten Ausführungsformen die Pumpleistung bzw. das Saugvermögen sozusagen mit dem Substrat auf der Einschleusseite oder allgemein mit der Evakuierungsrichtung von Atmosphäre zum Vakuum bzw. dem örtlichen Bedürfnis an Pumpleistung mitwandern, so dass von daher eine erhebliche Leistungssteigerung und Zeitverminderung einhergeht.

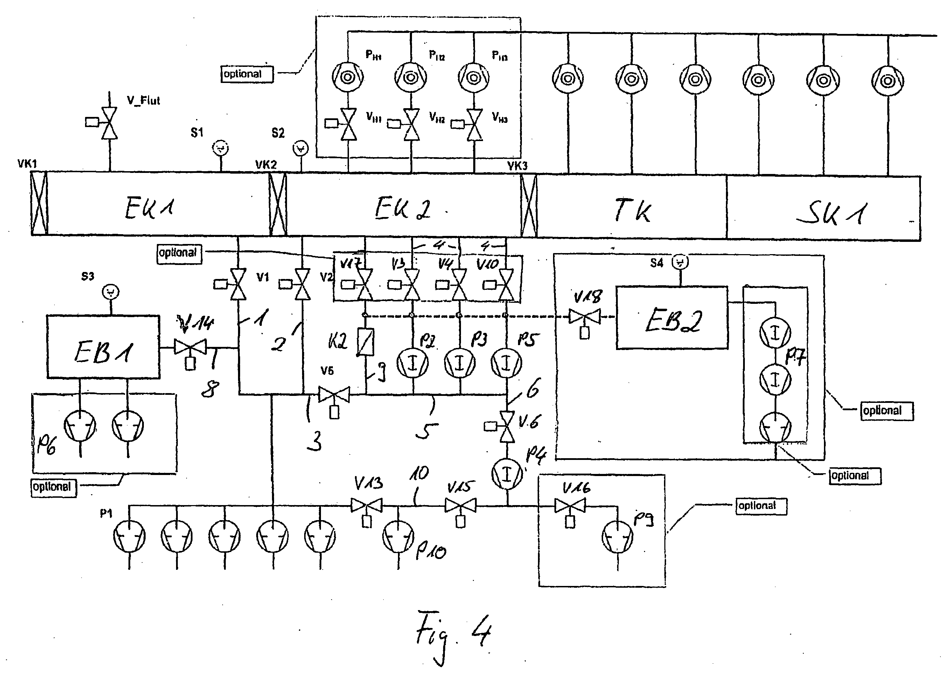

Die Fig. 4 zeigt eine weitere Ausführungsform einer erfindungsgemäßen Schleusenanordnung, die in großen Teilen mit derjenigen der Fig. 3 übereinstimmt.

Ein erster Unterschied besteht darin, dass die zweite Pumpeinrichtung mit den parallel geschalteten Pumpen P2, P3 und P5 keinen Bypass 8 parallel zur Pumpe P5 wie in Fig. 3 aufweist, sondern dass parallel zu den Leitungen 4, mit denen die Pumpen P2, P3 und P5 an der zweiten Einschleuskammer EK2 angeschlossen sind, eine druckdifferenzgesteuerte Umwegklappe K2 vorgesehen ist, die über die Leitung 9 und das Ventil V17 mit der zweiten Einschleuskammer EK2 verbunden ist. Mittels dieser Anordnung ist es möglich, die parallel geschalteten Rootspumpen P2, P3 und P5 bei relativ hohem Ansaugdruck zuzuschalten, um entsprechend dem eingestellten Differenzdruck auch schon bei hohen Ansaugdrücken einen Teil ihres Saugvermögens zum raschen Evakuieren zu nutzen. Die Umwegklappe K2 sorgt nämlich durch eine Verbindung der Ausblasseite der Pumpen P2, P3 und P5 mit der Ansaugseite über die zweite Einschleuskammer EK2 dafür, dass die Pumpen P2, P3 und P5 lediglich einen an der Umwegklappe K2 einstellbaren Differenzdruck bewältigen müssen. Hierzu kann beispielsweise die Umwegklappe aus einem federbelasteten oder gewichtsbelasteten Ventil bestehen, das sich bei einem festgelegten Überdruck auf der Ausblasseite der Rootspumpen P2, P3 und P5 in Kammerrichtung öffnet. Auf diese Weise können die Ventile V3, V4 und V10 bei höheren Ansaugdrücken geöffnet werden bzw. offen stehen bleiben und/oder es kann auf die Verwendung von voreinlassgekühlten Wälzkolbenpumpen, die ebenfalls bei höheren Drücken Verwendung finden könnten, verzichtet werden, so dass der Aufwand für die zweite Pumpeinrichtung bei gleichzeitiger Bereitstellung von höherem Saugvermögen reduziert werden kann. Selbstverständlich können statt der einen differenzdruckgesteuerten Umwegklappe K2 mehrere Differenzdruckklappen; beispielsweise für jede Pumpe P2, P3 oder P5 vorgesehen werden oder Rootspumpen mit integrierter Umwegklappe eingesetzt werden.

Die Anordnung der Umwegklappe K2 hat weiterhin den Vorteil, dass die Ventile V17, V3, V4 und V10 im Betrieb ständig geöffnet bleiben können, also nicht zwangsläufig in jedem Zyklus geschlossen werden müssen, insbesondere wenn auf die Hochvakuumpumpen $P_{H1}$ bis $P_{H3}$ verzichtet wird. Auf diese Weise wird der Betrieb ebenfalls vereinfacht.

Ein zweiter Unterschied der Ausführungsform der Fig. 4 gegenüber derjenigen der Fig. 3 ist dadurch gegeben, dass die parallel geschalteten Vakuumpumpen der ersten Pumpeneinrichtung P1 über eine Leitung 10 und den darin vorgesehenen Ventilen V13 und V15 als nachgeschaltete Stufe zur dritten Pumpeinrichtung P4 oder parallel zu weiteren Pumpen P9 über Ventil V16 und P10 über V13 zugeschaltet werden kann. Auf diese Weise ist es möglich, durch Schließen des Ventils V5 und Öffnen der Ventile V6, V13, V15 und eventuell V9 während des Abpümpens einen mehrstufigen Pumpstand mit der ersten Pumpeinrichtung P1, der vierten Pumpeinrichtung P4 und der zweiten Pumpeinrichtung P2, P3 und P5 zu bilden. So kann aus dem zweistufigen Pumpstand ohne Unterbrechung des Saugvermögens ein nahtloser Übergang zu einem dreistufigen Pumpstand erfolgen oder allgemein aus einem n-stufigen Pumpstand ein n+1-stufiger Pumpstand gebildet werden. Es ist klar, dass somit die Pumpe P9 mit dem Ventil V16 lediglich optional vorgesehen sein kann.

Ein weiterer wesentlicher Unterschied der Ausführungsform der Fig. 4 gegenüber den vorangegangen Ausführungsformen besteht darin, dass sie zusätzlich eine externe Puffereinrichtung EB1 aufweist, die über das Ventil V14 und die Leitung 8 sowie die Leitung 1 mit der ersten Schleusenkammer EK1 verbunden ist. Die Puffereinrichtung EB1 stellt ein Puffervolumen bereit, welches über die optional vorgesehene fünfte Pumpeinrichtung P6 oder über die erste Pumpeinrichtung P1 abgesaugt werden kann. Mit dem so vorhandenen evakuierten Puffervolumen kann der Druck in der ersten Schleusenkammer EK1 nach Öffnen der Ventile V1 und V14 schlagartig abgesenkt werden. Auf diese Weise ist es möglich Pumpleistung bzw. Saugvermögen in Zeiten zu nutzen, in denen die Pumpleistung bzw. das Saugvermögen für die direkte Evakuierung der Einschleuskammern EK1 und EK2 nicht benötigt wird oder das zusätzliche Versehen der fünften Pumpeinrichtung P6 an der Schleusenkammer EK1 auf Grund der Druckverhältnisse nicht vorteilhaft ist. Diese Pumpleistung bzw. das Saugvermögen wird sozusagen in der Puffereinrichtung EB1 gespeichert und dann bei Bedarf der ersten Schleusenkammer EK1 zur Verfügung gestellt.

In gleicher Weise kann auch die zweite Schleusenkammer EK2 als interne Puffereinrichtung wirken, wenn nämlich durch Öffnen der Ventile V1 und V2 ein Druckausgleich zwischen den Einschleuskammern EK1 und EK2 vorgenommen wird, so dass auch hier schlagartig der Druck abfällt. Insbesondere bei einer aufeinander abgestimmten Kombination eines Druckausgleichs zwischen erster Schleusenkammern EK1 und Puffereinrichtung EB1 und nachfolgendem Druckausgleich zwischen erster Schleusenkammer EK1 und zweiter Schleusenkammer EK2 können zwei Stufen einer raschen Druckabsenkung erzielt werden, wobei auch hier das Saugvermögen bezüglich der zweiten Schleusenkammer EK2 während eines größeren Zeitraumes des Schleusenprozesses Verwendung finden kann.

Zusätzlich kann optional eine zweite externe Puffereinrichtung EB2 mit entsprechend optional vorgesehener zusätzlicher sechster Pumpeinrichtung P7 vorgesehen werden, mittels der ein Druckausgleich zwischen der zweiten Einschleuskammer 2 und der zweiten Puffereinrichtung EB2 ebenfalls für eine schlagartige Druckabsenkung sorgt. Anstelle der sechsten Pumpeinrichtung P7 kann das Puffervolumen der zweiten Puffereinrichtung EB2 auch durch die zweite (P2, P3, P5), dritte (P4) und/oder weitere für die zweite Schleusenkammer EK2 bereits vorgesehene Pumpeinrichtungen, wie beispielsweise P9 evakuiert werden.

In der Ausführungsform der Fig. 4 ist auch angedeutet, dass die Hochvakuumpumpen $P_{H1}$ bis $P_{H3}$ in allen Ausführungsformen weggelassen werden können, und von daher also nur optional sind, wenn über das Saugvermögen für die zweite Schleusenkammer EK2 ein ausreichendes Vakuum erzielt werden kann.

Die Ventile V3, V4, V10 und V17 dienen dazu, die zweite Schleusenkammer EK2 vom Pumpstand trennen zu können und erlauben eine unabhängige Belüftung der Kammer bzw. des Pumpstands. Sofern dies nicht als erforderlich angesehen wird, können diese Ventile auch entfallen. Die Ventile V3, V4, V10 und V17 sind jedoch auf jeden Fall notwendig, wenn die zweite Puffereinrichtung EB2 über die zweite Pumpeinrichtung P2, P3, P5 evakuiert werden soll, da dann eine Abtrennung von der zweiten Schleusenkammer EK2 notwendig ist. Sollte jedoch die zweite Puffereinrichtung EB2 nur durch die sechste Pumpeinrichtung P7 evakuiert werden, könnte die zweite Puffereinrichtung EB2 auch direkt mittels V18 mit der zweiten Schleusenkammer EK2 verbunden sein.

Der Schleusenvorgang läuft bei der Ausführungsform gemäß der Fig. 4 in der folgenden Weise ab. Zunächst wird die Ventilklappe VK1 der ersten Schleusenkammer EK1 geöffnet und das Substrat wird in die erste Schleusenkammer EK1 transportiert. Dann wird die Ventilklappe VK1 geschlossen und das Ventil V1 zum Pumpenstand P1 geöffnet. Ventil V14 ist hierbei offen und die Ventile V2, V5 sowie V13 oder V15 sind geschlossen. Durch den Druckausgleich mit dem evakuierten Puffervolumen der ersten Puffereinrichtung EB1 der Druck in der ersten Schleusenkammer EK1 schlagartig von der Atmosphäre auf ca. 400 hPa gesenkt. Nunmehr wird V14 geschlossen und V2 geöffnet, so dass sich ein zweiter Druckausgleich anschließt, und zwar zwischen der ersten Schleusenkammer EK1 und der evakuierten zweiten Schleusenkammer EK2. Bei ungefähr gleichgroßen Kammervolumina von erster und zweiter Schleusenkammer EK1 und EK2 wird der Druck in beiden Kammern schlagartig auf ca. 200 hPa gebracht. Nunmehr wird die Ventilklappe VK2 geöffnet und das Substrat von der ersten Schleusenkammer EK1 in die zweite Schleusenkammer EK2 transportiert. Währenddessen wird das Ventil V5 geöffnet und die Ventile V1 und V2 werden geschlossen.

Gleichzeitig oder mit geringer Verzögerung werden die Ventile V6 und V15 und gegebenenfalls V13 geöffnet und das Ventil V5 geschlossen, so dass kein Bypass mehr zur dritten Pumpeinrichtung P4 besteht und nunmehr ein mehrstufiger Pumpbestand mit den Pumpstufen aus erster Pumpeinrichtung P1, zweiter Pumpeinrichtung P2, P3, P5 und dritter Pumpeinrichtung P4 besteht. Nunmehr wird die Ventilklappe VK2 geschlossen und die erste Schleusenkammer EK1 über das Ventil $V_{Flut}$ belüftet. Danach kann die Ventilklappe VK1 geöffnet und das nächste Substrat in die erste Schleusenkammer EK1 transportiert werden. Die optional vorhandenen Hochvakuumpumpen $P_{H1}$ bis $P_{H3}$ können nun durch das Öffnen der Ventile VH1 bis VH3 mit der zweiten Schleusenkammer EK2 in Verbindung gebracht werden. In diesem Fall werden die Ventile V3, V4, V10 und V17 geschlossen. Sind keine Hochvakuumpumpen an der zweiten Schleusenkammer EK2 vorgesehen, können diese Ventile im Betrieb ggf. durchgehend offen bleiben. Nunmehr kann die Ventilkappe VK3 geöffnet werden und das Substrat in den Prozessbereich bzw. die Transferkammer TK überführt werden. Die Ventile V13 und V15 werden geschlossen und das Ventil V14 wird geöffnet, so dass die erste Pumpeinrichtung das Puffervolumen der ersten Puffereinrichtung EB1 evakuieren kann: Falls die fünfte Pumpeinrichtung P6 vorhanden ist, kann das Puffervolumen der ersten Puffereinrichtung EB1 zusammen durch die erste Pumpeinrichtung P1 und die fünfte Pumpeinrichtung P6 evakuiert werden. Dann beginnt der Einschleusprozess von neuem.

Wird bei der Schleusenänordnüng der Fig. 4 die zweite externe Puffereinrichtung EB2 vorgesehen, so wird das Ventil V18 zum Druckausgleich zwischen zweiter Schleusenkammer EK2 und dem vorevakuierten Puffervolumen der zweiten Puffereinrichtung EB2 geöffnet, nachdem das Substrat die zweite Schleusenkammer EK2 erreicht hat und die Ventilklappe VK2, geschlossen wurde. Dadurch kann der Druck in der zweiten Schleusenkammer EK2 schlagartig von ca. 30 hPa auf 10, hPa abgesenkt werden.

Während des Transports des Substrats von der zweiten Schleusenkammer EK2 in die Transferkammer TK werden die Ventile V3, V4, V10 und V17 geschlossen, um die zweite Pumpeinrichtung mit den Pumpen P2, P3 und P5 zum Evakuieren des Puffervolumens der zweiten Puffereinrichtung EB2 zu nutzen.

Mit der vorgeschlagenen Lösung gemäß der Ausführungsform der Fig. 4 ist es aufgrund der Pufferlösungen möglich, in sehr kurzen Zeiten, d. h. Zeiten sehr viel kleiner als eine Sekunde, die Druckabsenkung über einen zweistufigen Druckausgleich in der ersten Schleusenkammer zu bewirken, um dann sofort das Substrat in die zweite Schleusenkammer überführen zu können. Mit einer zweiten Puffereinrichtung kann diese Wirkung auch für die zweite Schleusenkammer EK2 genutzt werden.

Die hier vorgestellten Vorgänge im Einschleusbereich können entsprechend analog auch für den Ausschleusbereich eingesetzt werden, ohne dass es hierfür einer näheren Beschreibung bedürfte, da der Fachmann die entsprechende Adaption in einfacher Weise vornehmen kann.

## Patentansprüche

1. Schleusenanordnung für eine Vakuumbehandlungsanlage mit Schleusenkammern (EK1, EK2) und einer ersten Pumpeinrichtung (P1) zum Abpumpen einer ersten Schleusenkammer sowie einer zweiten Pumpeinrichtung (P2, P3) zum Abpumpen einer zweiten Schleusenkammer, wobei
die Schleusenanordnung für eine kontinuierlich arbeitende Durchlaufbeschichtungsanlage vorgesehen ist, mit mindestens zwei hintereinander angeordneten Schleusenkammern (EK1, EK2) zur Durchführung eines zwei- oder mehrstufigen Schleusenvorgangs, worin
die erste Pumpeinrichtung (P1) über eine erste abschließbare Leitung (1) mit der ersten (EK1) und über eine zweite abschließbare Leitung (2) mit der zweiten (EK2) Schleusenkammer verbunden ist, so dass die erste Pumpeinrichtung entweder die erste oder die zweite oder beide Schleusenkammern zusammen abpumpen kann, und die erste Pumpeinrichtung (P1) über eine dritte abschließbare Leitung (3) mit der zweiten Pumpeinrichtung (P2, P3) verbunden ist, so dass die erste Pumpeinrichtung der zweiten Pumpeinrichtung in Reihe nachgeschaltet werden kann.

2. Schleusenanordnung nach Anspruch 1, **dadurch gekennzeichnet, dass** eine dritte Pumpeinrichtung (P4) vorgesehen ist, die über entsprechend abschließbare Leitungen (6) mit der zweiten Pumpeinrichtung (P2, P3) verbunden ist, so dass die dritte Pumpeinrichtung der zweiten Pumpeinrichtungen in Reihe nachgeschaltet werden kann.

3. Schleusenanordnung nach Anspruch 1 oder 2, **dadurch gekennzeichnet, dass** die Pumpeinrichtungen mehrere parallel und/oder in Reihe geschaltete Pumpen umfassen.

4. Schleusenanordnung nach einem der vorhergehenden Ansprüche, **dadurch gekennzeichnet, dass** die Pumpeinrichtungen ölabgedichtete und/oder trockenverdichtende Vakuumpumpen, insbesondere Drehschieberpumpen, Kreiskolbenpumpen, Sperrschieberpumpen, Wälzkolbenpumpen, Trockenläufer, insbesondere Schraubenpumpen, Rootspumpen, insbesondere voreinlassgekühlte Rootspumpen umfassen.

5. Schleusenanordnung nach einem der vorhergehenden Ansprüche, **dadurch gekennzeichnet, dass** die in einer Pumpeinrichtung parallel geschalteten Pumpen über einen abschließbaren Bypass (8) verfügen, über den zumindest eine der Pumpen zur Bildung eines mehrstufigen Pumpstandes gegenüber den anderen in Reihe geschaltet werden kann.

6. Schleusenanordnung nach einem der vorhergehenden Ansprüche, **dadurch gekennzeichnet, dass** an der zur Prozesskammer benachbarten Schleusenkammer über abschließbare Leitungen ein oder mehrere Hochvakuumpumpen ($P_{H1}$, $P_{H2}$, $P_{H3}$) angeordnet sind.

7. Schleusenanordnung nach einem der vorhergehenden Ansprüche, **dadurch gekennzeichnet, dass** parallel zu einer, insbesondere zur zweiten Pumpeinrichtung eine differenzdruckgesteuerte Umwegklappe (K2) geschaltet ist, die bei hohem Druck auf der Aussaugseite, insbesondere in der zweiten Schleusenkammer (EK2) einen Bypass von der Ausblas- zur Ansaugseite der Pumpeinrichtung (P2, P3, P5) darstellt, so dass eine vorzugsweise einstellbarer kritischer maximaler Differenzdruck über der parallel geschalteten Pumpeinrichtung nicht überschritten wird und das Saugvermögen der Pumpeinrichtung kontinuierlich druckabhängig genutzt wird.

8. Schleusenanordnung nach einem der Ansprüche 1 bis 7, **dadurch gekennzeichnet, dass** die erste Pumpeinrichtung (P1) mit ein oder mehreren parallel geschalteten ein-oder mehrstufigen, insbesondere atmosphärentauglichen Vakuumpumpen über eine erste Leitung (1), die ein erstes Ventil (1) aufweist, mit der ersten Schleusenkammer (EK1) und über eine zweite Leitung, die ein zweites Ventil aufweist, mit der zweiten Schleusenkammer (EK2) und über eine dritte Leitung, (3), die ein drittes Ventil (V5) aufweist, mit der zweiten Pumpeinrichtung (P2, P3) verbunden ist, wobei die zweite Pumpeinrichtung ein oder mehreren parallel geschaltete ein- oder mehrstufige Vakuumpumpen aufweist, die über eine vierte oder weitere Leitungen (4), die jeweils ein viertes Ventil (V3, V4) aufweisen, mit der zweiten Schleusenkammer (EK2) verbunden sind und wobei die parallel geschalteten Pumpen der zweiten Pumpeinrichtung untereinander über fünfte Leitungen (5) mit jeweils einem fünften Ventil (V7) untereinander verbunden sind.

9. Schleusenanordnung nach Anspruch 8, **dadurch gekennzeichnet, dass** an der Ausblasseite der zweiten Pumpeinrichtung (P2,P3), insbesondere an der die Pumpen (P2,P3) der zweiten Pumpeinrichtung verbindenden fünften Leitung (5) die dritte Pumpeinrichtung (P4) mit ein oder mehreren parallel geschalteten ein- oder mehrstufigen Vakuumpumpen über eine sechste Leitung (6) mit einem vorzugsweise vorgesehenen sechsten Ventil (V6) angeschlossen ist.

10. Schleusenanordnung nach Anspruch 8 oder 9, **dadurch gekennzeichnet, dass** die erste Pumpeinrichtung Drehschieberpumpen, die zweite Pumpeinrichtung Rootspumpen und die dritte Pumpeinrichtung zweistufige Rootspumpenstände oder einen einstufigen Pumpstand mit Drehschieberpumpen umfasst.

11. Schleusenanordnung nach einem der Ansprüche 8 bis 10, **dadurch gekennzeichnet, dass** zwischen der vierten (14) und der fünften (5) Leitung eine siebte Leitung (8) mit einem siebten Ventil (V11) vorgesehen ist, so dass eine parallel geschaltete Pumpe (P5) der zweiten Pumpeinrichtung gegenüber den anderen Pumpen in Reihe geschaltet werden kann.

12. Schleusenanordnung für eine Vakuumbehandlungsanlage mit Schleusenkammern (EK1, EK2) und einer ersten Pumpeinrichtung (P1) zum Abpumpen einer ersten Schleusenkammer (EK1), nach einem der vorhergehenden Ansprüche, **dadurch gekennzeichnet, dass**

die Schleusenanordnung für eine kontinuierlich arbeitende Durchlaufbeschichtungsanlage vorgesehen ist, mit mindestens zwei hintereinander angeordneten Schleusenkammern (EK1, EK2) zur Durchführung eines zwei- oder mehrstufigen Schleusenvorgangs, und

eine Puffereinrichtung (EB1) vorgesehen ist, die über abschließbare Leitungen (1, 8) mit der ersten Schleusenkammer (EK1) verbunden ist.

13. Schleusenanordnung nach Anspruch 12, **dadurch gekennzeichnet, dass** die Puffereinrichtung (EB1) eine fünfte Pumpeinrichtung (P6) aufweist, die das Puffervolumen abpumpt.

14. Schleusenanordnung nach einem der Ansprüche 12 oder 13, **dadurch gekennzeichnet, dass** die erste Pumpeinrichtung (P1) mit der Puffereinrichtung (EB1) verbunden ist.

15. Schleusenanordnung nach einem der Ansprüche 12 bis 14, **dadurch gekennzeichnet, dass** die Puffereinrichtung (EB1) über abschließbare Leitungen (2, 8) mit der zweiten Schleusenkammer (EK2) verbunden ist.

16. Schleusenanordnung nach einem der vorhergehenden Ansprüche, **dadurch gekennzeichnet, dass** eine zweite Puffereinrichtung (EB2) vorhanden ist, die über abschließbare Leitungen mit der zweiten Schleusenkammer (EK2) verbunden ist.

17. Schleusenanordnung nach Anspruch 16, **dadurch gekennzeichnet, dass** der zweiten Puffereinrichtung (EB2) eine sechste Pumpeinrichtung (P7) zugeordnet ist, die das Puffervolumen der zweiten Puffereinrichtung (EB2) abpumpt.

18. Schleusenanordnung nach einem der Ansprüche 3 bis 7, oder 12 bis 17 **dadurch gekennzeichnet, dass** die erste Pumpeinrichtung (P1) mit ein oder mehreren parallel geschalteten ein- oder mehrstufigen, insbesondere atmosphärentauglichen Vakuumpumpen über eine erste Leitung (1), die ein erstes Ventil (V1) aufweist, mit der ersten Schleusenkammer (EK1) und über eine zweite Leitung (2), die ein zweites Ventil (V2) aufweist, mit der zweiten Schleusenkammer (EK2) verbunden ist, wobei die zweite Pumpeinrichtung (P2, P3) ein oder mehrere parallel geschaltete ein- oder mehrstufige Vakuumpumpen aufweist, die über eine vierte oder weitere Leitungen (4), die jeweils ein viertes Ventil (V3, V4) aufweisen, mit der zweiten Schleusenkammer (EK2) verbunden sind und wobei die Ausblasseite der zweiten Pumpeinrichtung (P2,P3) über eine sechste Leitung (6) mit einem sechsten Ventil (V6) und die erste Pumpeinrichtung (P1) über eine achte Leitung (7) mit einem achten Ventil (V8) an die dritte Pumpeinrichtung (P4) mit ein oder mehreren parallel geschalteten ein- oder mehrstufigen Vakuumpumpen (P4a, P4b) angeschlossen ist.

19. Schleusenanordnung nach Anspruch 18, **dadurch gekennzeichnet, dass** die erste Pumpeinrichtung und die zweite Pumpeinrichtung Rootspumpen und die dritte Pumpeinrichtung Trockenläufer, insbesondere Schraubenpumpen umfasst.

20. Schleusenanordnung nach einem der vorhergehenden Ansprüche, **dadurch gekennzeichnet, dass** erste und zweite Schleusenkammer benachbart zueinander angeordnet sind und insbesondere erste und zweite Schleusenkammer einer zweistufigen oder dreistufigen Schleuse oder zweite und dritte Schleusenkammer einer dreistufigen Schleuse sind.

21. Schleusenanordnung nach einem der vorhergehenden Ansprüche, **dadurch gekennzeichnet, dass** die Schleusenkammern im Einschleus- und/oder Ausschleusbereich vorgesehen sind.

22. Schleusenanordnung nach einem der vorhergehenden Ansprüche, **dadurch gekennzeichnet, dass** die abschließbaren Leitungen Ventile umfassen, mittels derer die Leitungen gasdicht abschließbar sind.

23. Verfahren zum Betreiben einer mehrstufigen Schleusenanordnung nach einem der vorhergehenden Ansprüche, **dadurch gekennzeichnet, dass** das Verfahren zum Betreiben einer mehrstufigen Schleusenanordnung, mit wenigstens zwei hintereinander angeordneten Schleusenkammern (EK1, EK2) zur Durchführung eines zwei- oder mehrstufigen Schleusenvorgangs ist, worin eine erste Pumpeinrichtung (P1) nicht nur zum Abpumpen einer ersten Schleusenkammer (EK1), sondern auch zum Abpumpen einer zweiten Schleusenkammer (EK2) verwendet wird, wobei in einem Zyklus zunächst nur die erste Schleusenkammer, anschließend die erste und zweite Schleusenkammer und abschließend nur die zweite Schleusenkammer abgepumpt werden.

24. Verfahren nach Anspruch 23, **dadurch gekennzeichnet, dass** eine zweite Pumpeinrichtung (P2, P3) zum Abpumpen der zweiten Schleusenkammer (EK2) zusätzlich und/oder alternativ verwendet wird, wobei die erste Pumpeinrichtung (P1) auch als nachgeschaltete Pumpstufe der zweiten Pumpeinrichtung für die zweite Schleusenkammer eingesetzt wird.

25. Verfahren nach Anspruch 23, **dadurch gekennzeichnet, dass** eine zweite Pumpeinrichtung (P2, P3) zum Abpumpen der zweiten Schleusenkammer zusätzlich und/oder alternativ verwendet wird, wobei eine dritte Pumpeinrichtung (P4a, P4b) der ersten und zweiten Pumpeinrichtung nachgeschaltet ist, die abwechselnd die erste oder die zweite Pumpeinrichtung oder beide vorpumpt.

26. Verfahren nach einem der Ansprüche 23-25 zum Betreiben einer mehrstufigen Schleusenanordnung nach einem der Ansprüche 12 bis 22, **dadurch gekennzeichnet, dass** eine erste Schleusenkammer (EK1) durch Druckausgleich mit einer evakuierten Puffereinrichtung eine schlagartige Druckabsenkung erfährt.

27. Verfahren nach einem der Ansprüche 23 bis 26, **dadurch gekennzeichnet, dass** eine zweite Schleusenkammer (EK2) als interner Puffer dient, so dass durch schlagartigen Druckausgleich zwischen der abgepumpten zweiten Schleusenkammer (EK2) und der ersten Schleusenkammer (EK1) der Druck in der ersten Schleusenkammer (EK1) schlagartig abgesenkt wird.

28. Verfahren nach einem der Ansprüche 23 bis 27, **dadurch gekennzeichnet, dass ein** mehrstufiger, insbesondere zweistufiger Druckausgleich durch eine aufeinander folgende Abfolge von Druckausgleichen mit externen und/oder internen Puffereinrichtungen, insbesondere ein Druckausgleich durch unmittelbare Abfolge der Schritte nach dem kennzeichnenden Teil der Ansprüche 26 und 27 erfolgt.

29. Verfahren nach einem der Ansprüche 23 bis 28, **dadurch gekennzeichnet, dass** durch Druckausgleich zwischen einer evakuierten zweiten Puffereinrichtung (EB2) und der zweiten Schleusenkammer (EK2) der Druck in der zweiten Schleusenkammer (EK2) schlagartig abgesenkt wird.

## Claims

1. A load lock arrangement for a vacuum treatment installation with lock chambers (EK1, EK2) and a first pump device (P1) for evacuating a first lock chamber and a second pump device (P2,P3) for evacuating a second lock chamber, wherein the load lock arrangement is provided for a continuously operating, continuous coating installation with at least two lock chambers arranged behind one another for carrying out a two-or multi-stage locking process, wherein the first pump device (P1) is connected by means of a first closable conduit (1) to the first (EK1) and by means of a second closable conduit (2) to the second (EK2) lock chamber so that the first pump device can evacuate either the first or the second lock chamber or both lock chambers together and the first pump device (P1) is connected by means of a third closable conduit (3) to the second pump device (P2, P3) so that the first pump device can be connected in series downstream of the second pump device.

2. A load lock arrangement as claimed in Claim 1, **characterised in that** a third pump device(P4) is provided, which is connected by means of appropriately closable conduits (6) to the second pump device (P2, P3) so that the third pump device can be connected in series downstream of the second pump devices.

3. A load lock device as claimed in Claim 1 or 2, **characterised in that** the pump devices include a plurality of pumps connected in parallel and/or in series.

4. A load lock arrangement as claimed in one of the preceding claims, **characterised in that** the pump devices include oil sealed and/or dry vacuum pumps, particularly vane pumps, disc piston pumps, locking slide pumps, rotary piston pumps, dry-operating pumps, particularly screw pumps, Roots pumps, particularly inlet pre-cooled Roots pumps.

5. A load lock arrangement as claimed in one of the preceding claims, **characterised in that** the pumps connected in parallel in a pump device have a closable bypass (8), by means of which at least one of the pumps can be connected in series with respect to the others to form a multistage pump stand.

6. A load lock arrangement as claimed in one of the preceding claims, **characterised in that** one or more high vacuum pumps ($P_{H1}$, $P_{H2}$, $P_{H3}$) are arranged on the lock chamber adjacent to the process chamber by means of closable conduits.

7. A load lock arrangement as claimed in one of the preceding claims, **characterised in that** connected in parallel with one pump device, particularly the second pump device, there is a differential pressure-controlled bypass flap (K2), which, in the event of high pressure on the outlet side, particularly in the second lock chamber (EK2) constitutes a bypass from the outlet side to the inlet side of the pump device (P2, P3, P5), so that a preferably adjustable, critical maximum differential pressure across the parallel connected pump device is not exceeded and the vacuum capacity of the pump device is used continuously in pressure-dependant manner.

8. A load lock arrangement as claimed in one of Claims 1 to 7, **characterised in that** the first pump device (P1) with one or more single- or multi-stage vacuum pumps connected in parallel, particularly of the type usable in the atmosphere, is connected by means of a first conduit (1), which includes a first valve (1), to the first lock chamber (EK1) and by means of a second conduit, which includes a second valve, to the second lock chamber (EK2) and by means of a third conduit (3), which includes a third valve (V5), to the second pump device (P2, P3), wherein the second pump device includes one or more single- or multi-stage vacuum pumps, which are connected in parallel and are connected by means of a fourth or further conduits (4), each of which includes a fourth valve (V3,V4), to the second lock chamber (EK2) and wherein the pumps, which are connected in parallel, of the second pump device are connected together by means of fifth conduits (5) with a respective fifth valve (V7).

9. A load lock arrangement as claimed in Claim 8, **characterised in that** at the outlet side of the second pump device, (P2,P3), particularly at the fifth conduit (5) connecting the pumps (P2,P3) of the second pump device, the third pump device (P4) is connected to one or more single- or multi-stage vacuum pumps, which are connected in parallel, by means of a sixth conduit (6) with a sixth valve (V6), which is preferably provided.

10. A load lock arrangement as claimed in Claim 8 or 9, **characterised in that** the first pump device includes rotary disc pumps, the second pump device includes Roots pumps and the third pump device includes two-stage Roots pump stands or a singlestage pump stand with rotary disc pumps.

11. A load lock arrangement as claimed in one of Claims 8 to 10, **characterised in that** provided between the fourth (14) and the fifth (5) conduit there is a seventh conduit (8) with a seventh valve (V11) so that a pump (P5), which is connected in parallel, of the second pump device can be connected in series with respect to the other pumps.

12. A load lock arrangement for a vacuum treatment installation with lock chambers (EK1, EK2) and a first pump device (P1) for evacuating a first lock chamber (EK1) as claimed in one of the preceding claims, **characterised in that** the load lock arrangement is provided for a continuously operating continuous coating installation with at least two lock chambers (EK1, EK2) arranged behind one another for carrying out a two- or multi-stage locking process and a buffer device (EB1) is provided, which is connected to the first lock chamber (EK1) by means of closable conduits (1,8).

13. A load lock arrangement as claimed in Claim 12, **characterised in that** the buffer device (EB1) includes a fifth pump device (P6), which evacuates the buffer volume.

14. A load lock arrangement as claimed in one of Claims 12 or 13, **characterised in that** the first pump device (P1) is connected to the buffer device (EB1).

15. A load lock arrangement as claimed in one of Claims 12 to 14, **characterised in that** the buffer device (EB1) is connected to the second lock chamber (EK2) by means of closable conduits (2,8).

16. A load lock arrangement as claimed in one of the preceding claims, **characterised in that** a second buffer device (EB2) is present, which is connected to the second lock chamber (EK2) by means of closable conduit.

17. A load lock arrangement as claimed in Claim 16, **characterised in that** associated with the second buffer device (EB2) there is a sixth pump device (P7), which evacuates the buffer volume of the second buffer device (EB2).

18. A load lock arrangement as claimed in one of Claims 3 to 7 or 12 to 17, **characterised in that** the first pump device (P1) with one or more single- or multi-stage vacuum pumps, particularly of the type usable in the atmosphere, which are connected in parallel is connected to the first lock chamber (EK1) by means of a first conduit (1), which includes a first valve (V2), and to the second lock chamber (EK2) by means of a second conduit (2), which includes a second valve (V2), wherein the second pump device (P2,P3) includes one or more single- or multi-stage vacuum pumps, which are connected in parallel and are connected to the second lock chamber (EK2) by means of a fourth or further conduits (4), which include a respective fourth valve (V3,V4), and wherein the outlet side of the second pump device (P2,P3) and the first pump device (P1) are connected by means of a sixth conduit (6) with a sixth valve and by means of an eighth conduit (7) with an eighth valve (V8), respectively to the third pump device (P4) with one or more single- or multi-stage vacuum pumps (P4a, P4b), which are connected in parallel.

19. A load lock arrangement as claimed in Claim 18, **characterised in that** the first pump device and the second pump device include Roots pumps and the third pump device includes dry running pumps, particularly screw pumps.

20. A load lock arrangement as claimed in one of the preceding claims, **characterised in that** the first and second lock chambers are arranged adjacent to one another and, in particular, are the first and second lock chambers of a two-stage or three-stage lock or the second and third lock chambers of a three-stage lock.

21. A load lock arrangement as claimed in one of the preceding claims, **characterised in that** the lock chambers are provided in the charging or discharging region.

22. A load lock arrangement as claimed in one of the preceding claims, **characterised in that** the closable conduits include valves, by means of which the conduits may be sealed in gas-tight manner.

23. A method of operating a multi-stage load lock arrangement as claimed in one of the preceding claims, **characterised in that** the method of operating a multi-stage load lock arrangement with two lock chambers (EK1,EK2) arranged behind one another is for carrying out a two- or multi-stage process, wherein a first pump device (P1) is used not only for evacuating a first lock chamber (EK1) but also for evacuating a second lock chamber (EK2), wherein within a cycle firstly only the first lock chamber, subsequently the first and second lock chambers and then only the second lock chamber are evacuated.

24. A method as claimed in Claim 23, **characterised in that** a second pump device, (P2,P3) is additionally and/or alternatively used for evacuating the second lock chamber (EK2) wherein the first pump device (P1) is also used as a downstream pump stage of the second pump device for the second lock chamber.

25. A method as claimed in Claim 23, **characterised in that** a second pump device (P2,P3) is used additionally and/or alternatively for evacuating the second lock chamber, wherein a third pump device (P4a,P4b), is connected downstream of the first and second pump device, which forepumps the first or the second pump device alternately or both of them.

26. A method as claimed in one of the Claims 23 to 25 of operating a multi-stage load lock arrangement as claimed in one of Claims 12 to 22, **characterised in that** a first lock chamber (EK1) experiences an abrupt pressure reduction as a result of pressure equalisation with an evacuated buffer device.

27. A method as claimed in one of the Claims 23 to 26, **characterised in that** a second lock chamber (EK2) serves as an internal buffer so that the pressure in the first lock chamber (EK1) is reduced abruptly as a result of abrupt pressure equalisation between the evacuated second lock chamber (EK2) and the first lock chamber (EK1).

28. A method a claimed in one of the Claims 23 to 27, **characterised in that** a multi-stage, particularly two-stage, pressure equalisation occurs as a result of a successive sequence of pressure equalisation with external and/or internal buffer devices, particularly a pressure equalisation as a result of a direct sequence of the steps in accordance with the characterising portion of Claims 26 and 27.

29. A method a claimed in one of the Claims 23 to 28, **characterised in that** the pressure in the second lock chamber (EK2) is abruptly reduced as a result of pressure equalisation between an evacuated second buffer device (EB2) and the second lock chamber (EK2).

**Revendications**

1. Système d'écluse pour une installation de traitement sous vide, comprenant des sas (EK1, EK2) et un premier dispositif de pompage (P1) destiné à faire le vide dans un premier sas ainsi qu'un deuxième dispositif de pompage (P2, P3) destiné à faire le vide dans un deuxième sas,
le système d'écluse est prévu pour une installation de revêtement en continu qui fonctionne de manière ininterrompue, comprenant au moins deux sas successifs (EK1, EK2) pour réaliser un éclusage sur deux étages ou plus, dans lequel
le premier dispositif de pompage (P1) est relié au premier (EK1) par l'intermédiaire d'un premier conduit obturable (1) et au deuxième sas (EK2) par l'intermédiaire d'un deuxième conduit obturable (2), de sorte que le premier dispositif de pompage peut faire le vide dans le premier ou dans le deuxième ou dans les deux sas, et le premier dispositif de pomage (P1) est relié au deuxième dispositif de pomage (P2, P3) par l'intermédiaire d'un troisième conduit obturable (3), de sorte que le premier dispositif de pomage peut être monté en série en aval du deuxième dispositif de pomage.

2. Système d'écluse selon la revendication 1, **caractérisé en ce qu'**un troisième dispositif de pompage (P4), qui est relié au deuxième dispositif de pompage (P2, P3) par l'intermédiaire de conduites obturables correspondantes (6), est prévu de sorte que le troisième dispositif de pompage peut être monté en série en aval du deuxième dispositif de pompage.

3. Système d'écluse selon la revendication 1 ou 2, **caractérisé en ce que** les dispositifs de pompage comprennent plusieurs pompes montées en parallèle et/ou en série.

4. Système d'écluse selon l'une quelconque des revendications précédentes, **caractérisé en ce que** les dispositifs de pompage comprennent des pompes à vide étanches à l'huile et/ou fonctionnant à sec, en particulier des pompes à tiroirs rotatifs, des pompes à piston tournant, des pompes à tiroirs fermants, des dépresseurs de Roots, des rotors secs, en particulier des pompes à vis, des pompes Roots, en particulier des pompes Roots refroidies au niveau de l'admission.

5. Système d'écluse selon l'une quelconque des revendications précédentes, **caractérisé en ce que** les pompes montées en parallèle dans un dispositif de pompage sont équipées d'un bypass (8) obturable, grâce auquel au moins l'une des pompes peut être montée en série par rapport aux autres pour former un banc de pompage à plusieurs étages.

6. Système d'écluse selon l'une quelconque des revendications précédentes, **caractérisé en ce qu'**une ou plusieurs pompes à vide poussé ($P_{H1}$, $P_{H2}$, $P_{H3}$) sont disposées au niveau du sas adjacent à la chambre de traitement par l'intermédiaire de conduites obturables.

7. Système d'écluse selon l'une quelconque des revendications précédentes, **caractérisé en ce que,** parallèlement à un, en particulier au deuxième, dispositif de pompage est monté un clapet de dérivation (K2) commandé par la pression différentielle, lequel, en cas de pression élevée côté évacuation, en particulier dans le deuxième sas (EK2), constitue un bypass du côté évacuation vers le côté aspiration du dispositif de pompage (P2, P3, P5), de sorte qu'une pression différentielle maximale critique, de préférence ajustable, n'est pas dépassée dans le dispositif de pompage monté en parallèle et la capacité d'aspiration du dispositif de pompage est utilisée en continu en fonction de la pression.

8. Système d'écluse selon l'une quelconque des revendications 1 à 7, **caractérisé en ce que** le premier dispositif de pompage (P1) comprenant une ou plusieurs pompes à vide à un ou plusieurs étages, en particulier appropriées à la pression atmosphérique, montées en parallèle, est relié, par l'intermédiaire d'une première conduite (1), qui présente une première vanne (1), au premier sas (EK1) et, par l'intermédiaire d'une deuxième conduite, qui présente une deuxième vanne, au deuxième sas (EK2) et, par l'intermédiaire d'une troisième conduite (3), qui présente une troisième vanne (V5), au deuxième dispositif de pompage (P2, P3), le deuxième dispositif de pompage présentant une ou plusieurs pompes à vide à un ou plusieurs étages montées en parallèle, lequel est relié, par l'intermédiaire d'une quatrième ou d'autres conduites (4), qui présentent chacune une quatrième vanne (V3, V4), au deuxième sas (EK2), et les pompes montées en parallèle du deuxième dispositif de pompage étant reliées les unes aux autres par l'intermédiaire d'une cinquième conduite (5) comprenant une cinquième vanne (V7).

9. Système d'écluse selon la revendication 8, **caractérisé en ce que,** du côté évacuation du deuxième dispositif de pompage (P2, P3), en particulier au niveau de la cinquième conduite (5) reliant les pompes (P2, P3) du deuxième dispositif de pompage, le troisième dispositif de pompage (P4) comprenant une ou plusieurs pompes à vide à un ou plusieurs étages montées en parallèle est raccordé, par l'intermédiaire d'une sixième conduite (6), à une sixième vanne (V6) prévue de manière préférée.

**10.** Système d'écluse selon la revendication 8 ou 9, **caractérisé en ce que** le premier dispositif de pompage comprend des pompes à tiroirs rotatifs, le deuxième dispositif de pompage comprend des pompes Roots et le troisième dispositif de pompage comprend des bancs de pompage Roots à deux étages ou un banc de pompage à un étage avec des pompes à tiroirs rotatifs.

**11.** Système d'écluse selon l'une quelconque des revendications 8 à 10, **caractérisé en ce qu'**une septième conduite (8) avec une septième vanne (V11) est prévue entre la quatrième (14) et la cinquième (5) conduite, de sorte qu'une pompe (P5), montée en parallèle, du deuxième dispositif de pompage peut être montée en série par rapport aux autres pompes.

**12.** Système d'écluse pour une installation de traitement sous vide, comprenant des sas (EK1, EK2) et un premier dispositif de pompage (P1) destiné à faire le vide dans un premier sas (EK1), selon l'une quelconque des revendications précédentes, **caractérisé en ce que**

le système d'écluse est prévu pour une installation de revêtement en continu qui fonctionne de manière ininterrompue, comprenant au moins deux sas successifs (EK1, EK2) pour réaliser un éclusage sur deux étages ou plus, et
un dispositif tampon (EB1) relié au premier sas (EK1) par l'intermédiaire de conduites obturables (1, 8), est prévu.

**13.** Système d'écluse selon la revendication 12, **caractérisé en ce que** le dispositif tampon (EB1) présente un cinquième dispositif de pompage (P6), qui évacue le volume tampon.

**14.** Système d'écluse selon l'une quelconque des revendications 12 ou 13, **caractérisé en ce que** le premier dispositif de pompage (P1) est relié au dispositif tampon (EB1).

**15.** Système d'écluse selon l'une quelconque des revendications 12 à 14, **caractérisé en ce que** le dispositif tampon (EB1) est relié au sas (EK2) par l'intermédiaire de conduites obturables (2, 8).

**16.** Système d'écluse selon l'une quelconque des revendications précédentes, **caractérisé en ce qu'**un deuxième dispositif tampon (EB2), qui est relié au deuxième sas (EK2) par l'intermédiaire de conduites obturables, est présent.

**17.** Système d'écluse selon la revendication 16, **caractérisé en ce qu'**au deuxième dispositif tampon (EB2) est associé un sixième dispositif de pompage (P7), qui évacue le volume tampon du deuxième dispositif tampon (EB2).

**18.** Système d'écluse selon l'une quelconque des revendications 3 à 7, ou 12 à 17, **caractérisé en ce que** le premier dispositif de pompage (P1) comprenant une ou plusieurs pompes à vide à un ou plusieurs étages, en particulier appropriées à la pression atmosphérique, montées en parallèles, est relié, par l'intermédiaire d'une première conduite (1), qui présente une première vanne (V1), au premier sas (EK1) et, par l'intermédiaire d'une deuxième conduite (2), qui présente une deuxième vanne (V2), au deuxième sas (EK2), dans lequel le deuxième dispositif de pompage (P2, P3) présente une ou plusieurs pompes à vide à un ou plusieurs étages montées en parallèle, qui sont reliées, par l'intermédiaire d'une quatrième ou d'autres conduites (4), qui présentent chacune une quatrième vanne (V3, V4), au deuxième sas (EK2), et dans lequel le côté évacuation du deuxième dispositif de pompage (P2, P3), par l'intermédiaire d'une sixième conduite (6) présentant une sixième vanne (V6), et le premier dispositif de pompage (P1), par l'intermédiaire d'une huitième conduite (7) présentant une huitième vanne, sont raccordés au troisième dispositif de pompage (P4) comprenant une ou plusieurs pompes à vide (P4a, P4b) à un ou plusieurs étages montées en parallèle.

**19.** Système d'écluse selon la revendication 18, **caractérisé en ce que** le premier dispositif de pompage et le deuxième dispositif de pompage comprennent des pompes Roots et le troisième dispositif de pompage comprend des rotors secs, en particulier des pompes à vis.

**20.** Système d'écluse selon l'une quelconque des revendications précédentes, **caractérisé en ce que** les premier et deuxième sas sont disposés côte à côte et, en particulier, les premier et deuxième sas sont des sas à deux ou trois étages ou les deuxième et troisième sas sont des sas à trois étages.

**21.** Système d'écluse selon l'une quelconque des revendications précédentes, **caractérisé en ce que** les sas sont prévus dans la zone d'entrée et/ou de sortie.

**22.** Système d'écluse selon l'une quelconque des revendications précédentes, **caractérisé en ce que** les conduites obturables comprennent des vannes, au moyen desquelles les conduites peuvent être obturées de manière étanche au gaz.

**23.** Procédé pour faire fonctionner un système d'écluse à plusieurs étages selon l'une quelconque des revendications précédentes, **caractérisé en ce que** le procédé sert à faire fonctionner un système d'écluse à plusieurs étages, comprenant au moins deux sas successifs (EK1, EK2) pour réaliser un éclusage sur deux étages ou plus, dans lequel

un premier dispositif de pompage (P1) est utilisé non seulement pour faire le vide dans un premier sas (EK1) mais également pour faire le vide dans un deuxième sas (EK2), dans lequel, dans un cycle, d'abord seul le premier sas est évacué, puis ce sont les premier et deuxième sas qui sont évacués et enfin seul le deuxième sas est évacué.

24. Procédé selon la revendication 23, **caractérisé en ce qu'**un deuxième dispositif de pompage (P2, P3) pour faire le vide dans le deuxième sas (EK2) est utilisé en plus et/ou en variante, dans lequel le premier dispositif de pompage (P1) est également mis en oeuvre en tant qu'étage de pompage en aval du deuxième dispositif de pompage pour le deuxième sas.

25. Procédé selon la revendication 23, **caractérisé en ce qu'**un deuxième dispositif de pompage (P2, P3) pour faire le vide dans le deuxième sas (EK2) est utilisé en plus et/ou en variante, dans lequel un troisième dispositif de pompage (P4a, P4b) est monté en aval des premier et deuxième dispositifs de pompage, lequel fait le vide en alternance dans le premier ou dans le deuxième dispositif de pompage ou dans les deux.

26. Procédé selon l'une quelconque des revendications 23 à 25 pour faire fonctionner un système d'écluse à plusieurs étages, selon l'une quelconque des revendications 12 à 22, **caractérisé en ce que** un premier sas (EK1) subit une chute de pression soudaine par équilibrage de pression avec un dispositif tampon sous vide.

27. Procédé selon l'une quelconque des revendications 23 à 26, **caractérisé en ce qu'**un deuxième sas (EK2) sert de tampon interne, de sorte que l'équilibrage de pression soudain entre le deuxième sas évacué (EK2) et le premier sas (EK1) fait soudainement chuter la pression dans le premier sas (EK1).

28. Procédé selon l'une quelconque des revendications 23 à 27, **caractérisé en ce qu'**un équilibrage de pression à plusieurs étages, en particulier à deux étages, est obtenu par une suite successive d'équilibrages de pression avec des dispositifs tampons externes et/ou internes, en particulier un équilibrage de pression par une suite immédiate des étapes selon la partie caractérisante des revendications 26 et 27.

29. Procédé selon l'une quelconque des revendications 23 à 28, **caractérisé en ce qu'**un équilibrage de pression entre un deuxième dispositif tampon sous vide (EB2) et le deuxième sas (EK2) fait chuter soudainement la pression dans le deuxième sas (EK2).

Fig. 1

Fig. 2

EP 1 582 607 B2

Fig. 3

EP 1 582 607 B2

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4504194 A